# EUROPÄISCHE PATENTSCHRIFT

(11) **EP 2 070 097 B1**
(45) Veröffentlichungstag und Bekanntmachung des Hinweises auf die Patenterteilung: **19.12.2012**
(21) Anmeldenummer: 07800660.8
(22) Anmeldetag: 24.09.2007
(51) Int. Cl.: H01H 13/705

(54) **TASTE FÜR SMT-ANWENDUNGEN**
BUTTON FOR SMT APPLICATIONS
TOUCHE POUR APPLICATIONS DE LA TECHNOLOGIE DE MONTAGE EN SURFACE

(30) Priorität: 03.10.2006 CH 15722006
(43) Veröffentlichungstag der Anmeldung: 17.06.2009
(73) Patentinhaber: Abatek International AG, 8303 Bassersdorf (CH)
(72) Erfinder: KEIST, Christoph, 9630 Wattwil (CH)
(74) Vertreter: Bremi, Tobias Hans
(86) Internationale Anmeldenummer: PCT/CH2007/000469
(87) Internationale Veröffentlichungsnummer: WO 2008/040132

(56) Entgegenhaltungen:
- EP-A2- 0 036 570
- EP-A2- 0 938 111
- EP-A2- 1 037 226
- DE-A1- 4 317 176
- DE-B3- 10 255 338
- JP-A- 2001 184 984

## Beschreibung

### TECHNISCHES GEBIET

Die vorliegende Erfindung betrifft eine Taste zur intermittierenden elektrischen Kontaktierung wenigstens zweier, auf einer Leiterplatte angeordneter Leiter mit einem elektrisch leitenden Kontaktelement, insbesondere zur Befestigung auf der Leiterplatte im Rahmen von SMT-Technologie. Dabei weist die Taste wenigstens eine auf der Leiterplatte angeordnete Basis sowie einen bezüglich der Leiterplatte und der Basis beweglichen Tastenkopf mit dem Kontaktelement auf, wobei der Tastenkopf über wenigstens eine bewegliche Membran mit der Basis verbunden ist, und wobei Basis und Membran aus einen isolierenden elastischen Material bestehen. Des Weiteren betrifft die vorliegende Erfindung Verfahren zur Herstellung einer derartigen Taste oder Anordnungen von derartigen Tasten und Verwendungen von solchen Tasten.

### STAND DER TECHNIK

Kontakttastenschalter werden beispielsweise für Mobiltelefone, Fernbedienungen aber auch für Anwendungen beispielsweise in Fahrzeugen etc. verwendet. Sie beruhen normalerweise auf Tasten oder Anordnungen von Tasten, welche aus einem gummiartigen elastischen Material bestehen (normalerweise Silikon), welche auf einer Leiterplatte angeordnet sind, und wobei auf der Unterseite eines eigentlichen Tastenkopfes ein Kontaktelement (beispielsweise eine Kontaktpille aus Metall oder Carbon) angeordnet ist, so dass bei einem herunterdrücken dieses Tastenkopfes das Kontaktelement derart auf die Leiterplatte gedrückt wird, dass darauf angeordnete Leiter miteinander verbunden werden. Derartige Konstruktionen sind beispielsweise in der EP 0938111 offenbart.

Es bestehen heute zwei grundsätzliche Lösungsansätze zur Realisierung einer solchen Tastatur mit darüber liegender Plastikkappe.

Die erste Lösung sind Silikon-Schaltmatten mit mindestens einem Schaltdom, in der Regel aber meistens mehreren Schaltdomen auf einer Matte. Die Schaltdome werden über die Plastikkappe betätigt und liefern eine klar definierte Kraft-Weg Kennlinie (taktile Rückmeldung). Beim Berühren von der elektrisch leitfähigen Kontaktpille mit der Leiterplatte wird der Kontakt geschlossen und der Schalter ist somit betätigt. Schaltmatten werden meistens von Hand auf die Leiterplatte aufgelegt. Eine Hinterleuchtung der Plastikkappen geschieht mittels auf der Leiterplatte aufgebrachten LED's (Light Emitting Diode).

Die zweite Lösung sind so genannte Tact-Switches. Tact Switches sind einzelne Schaltdome, welche mit einem oder mehreren Füsschen versehen sind, welche auf der Leiterplatte angelötet werden. Die Montage erfolgt meistens automatisch im SMT Verfahren (Surface Mount Technology). Die heute verfügbaren Tact Switches sind aufwändig gebaut und daher sehr teuer. Hinterleuchtung der Plastikkappen geschieht meistens mittels auf der Leiterplatte aufgebrachten LED's, neuere Varianten haben aber auch bereits im Tact Switch integrierte Hinterleuchtung. Meist stehen nur wenige Kraft-Weg Varianten zur Verfügung.

Aus der EP0036570 ist eine Tastatur mit einer Trägerplatte bekannt, auf der Leiterbahnen und Kontaktflächen aufgebracht sind. Den Kontaktflächen zugeordnet sind Drucktasten, die aus einem elastisch deformierbaren Schnappelement bestehen, wobei ein Kontaktelement des Schnappelementes durch Deformation bei Betätigung eines Betätigungsknopfes mit den Kontaktflächen in Berührung bringbar ist. Um die Tastatur mechanisch stabil herstellen zu können und um auch bei grösseren Abmessungen den Einfluss des Schrumpfmasses nahezu völlig zu beseitigen, wird vorgeschlagen als Halterung für die Schnappelemente einen Metallrahmen vorzusehen. Dieser besitzt eine Reihe von herausgeprägten Vorsprüngen. Jeder der Vorsprung besitzt eine Öffnung, in der das Schnappelement gehaltert ist.

Aus der DE4317176 ist eine Schalterkappe aus einer Kunststoff-Spritzmasse bekannt, die als Betätigungsorgan und Rückstellelement für einen Drucktastenschalter dient. Die Schalterkappe weist einen Basissockel, einen gegenüber diesem Basissockel schmaleren Deckel und eine den Basissockel und den Deckel verbindende flexible dünnwandige Membran auf. Eine Kontaktfläche zur Überbrückung von auf einem Trägerteil angeordneten Festkontakten ist am Basissockel an seiner dem Deckel zugewandten Fläche angebracht. Die Hubbewegung zur Betätigung der Schalterkappe erfolgt durch den Basissockel in Richtung zum Deckel. Der Deckel und das Trägerteil sind mittels eines Befestigungsteiles kraftschlüssig miteinander verbunden.Aus der JP 2001 184984 ist eine Taste zur intermittierenden elektrischen Kontaktierung auf einer Leiterplatte angeordneter Leiter mit einem elektrisch leitenden Kontaktelement bekannt, wobei die Taste eine auf der Leiterplatte angeordnete Basis sowie einen bezüglich der Leiterplatte und der Basis beweglichen Tastenkopf mit dem Kontaktelement oder ein darunter angeordnetes Kontaktelement aufweist, wobei der Tastenkopf über wenigstens eine bewegliche Membran mit der Basis verbunden ist, und wobei Basis und Membran aus einem isolierenden elastischen Material bestehen. Die Taste weist dabei zusätzlich einen Lötfuss auf, welcher mit seinem ersten Ende in der Basis eingelassen ist und mit dessen zweitem Ende, dem Lötbereich, die Taste an der Leiterplatte befestigt werden kann,

### DARSTELLUNG DER ERFINDUNG

Der Erfindung liegt demnach die Aufgabe zugrunde, eine verbesserte Taste respektive einen verbesserten Kontakttastenschalter zur Verfügung zu stellen. Konkret geht es insbesondere darum, eine Taste mit taktiler Rückmeldung zur intermittierenden elektrischen Kontaktierung wenigstens zweier, auf einer Leiterplatte angeordneter Leiter mit einem elektrisch leitenden Kontaktelement (z. B. Kontaktpille, el. Leitfähige Beschichtung oder Metalldom) zu verbessern. Dabei verfügt die Taste über wenigstens eine auf der Leiterplatte angeordnete Basis sowie einen bezüglich der Leiterplatte und der Basis beweglichen (normalerweise absenkbaren) Tastenkopf mit dem Kontaktelement oder mit darunter liegendem Kontaktelement in Form eines Metalldomes, der die taktile Rückmeldung und den elektrischen Kontakt gewährleistet. Der Tastenkopf ist über wenigstens eine bewegliche Membran mit der Basis verbunden, und die Basis und die Membran bestehen aus einem isolierenden elastischen Material, z.B. (transparentes) Silikon.

Die Verbesserung wird durch die Merkmale von Anspruch 1 erreicht, d.h. unter anderem dadurch, dass die Taste zusätzlich wenigstens einen Lötfuss aufweist, welcher mit seinem ersten Ende formschlüssig in der Basis eingelassen ist und mit dessen zweitem Ende, dem freiliegenden Lötbereich, die Taste auf der Leiterplatte befestigt werden kann. Unter "formschlüssig eingelassen" ist dabei zu verstehen, dass der Lötfuss derart in der Basis eingelassen ist, dass er nicht ohne Gewaltanwendung aus der Basis entnommen oder herausgezogen werden kann.

Der Kern der Erfindung besteht somit unter anderem darin, die Möglichkeit der Befestigung der Taste, konkret die Lötfüsse, nicht nachträglich an der Basis zu befestigen (z.B. durch Kleben oder Klemmen) sondern mit dem einen, nicht freiliegenden Ende im wesentlichen vollständig und formschlüssig in der Basis einzubetten. Der Formschluss wird dabei bevorzugtermassen dadurch verstärkt, dass das nicht freiliegende Ende derart ausgebildet ist, dass es nicht ohne Zerstörung der Basis aus dieser herausgezogen werden kann. Dies ist beispielsweise möglich, indem bei streifenförmiger Ausbildung des Lötfusses Stufen, Winkel, Krümmungen oder Wellen im nicht freiliegenden Ende vorgesehen werden, oder indem das nicht freiliegende Ende nicht als Streifen ausgebildet ist sondern gewissermassen T- oder L-förmig, so dass es in der Basis gehalten wird. Die Basis ist normalerweise ein umlaufender Ring (rund, oval oder eckig, auch mit abgerundeten Ecken) aus elastischem Material, gleich wie der Tastenkopf, normalerweise handelt es sich beim elastischen Material um Silikon.

Ziel dieser Erfindung ist es also, einen automatisch bestückbaren Schaltdom zur Verfügung zu stellen mit folgenden (einzeln oder in Kombination auftretenden und insbesondere in ihrer Kombination einzigartigen) Eigenschaften:
- sehr kostengünstig;
- automatische Montage mittels SMT, Anlieferung auf Rollen;
- kleinste mögliche Baugrösse;
- sowohl mit kurzem Hub 0.2mm-0.8mm (Metalldom) als auch mit langem Hub 0.8mm-3mm (Schaltmatte);
- grosse Auswahl an Kran-Weg Kennlinien (auf Kundenbedürfnis abgestimmt);
- mit integrierter LED zur Hinterleuchtung als Option.

Gemäss einer ersten bevorzugten Ausführungsform sind zwei auf gegenüberliegenden Seiten der Taste respektive der Basis angeordnete Lötfüsse vorhanden. So kann die Taste optimal auf der Leiterplatte befestigt werden, beispielsweise in einem Lötvorgang.

Nach der Erfindung ist die Basis als auf der Leiterplatte um die Position der zu kontaktierenden Leiter umlaufendes Element ausgebildet, aus welchem der wenigstens eine Lötfuss seitlich herausragt. Mit anderen Worten liegt der Lötfuss auf der Leiterplatte auf. Der Lötfuss weist einen flächigen, auf der Leiterplatte und parallel zu dieser aufliegenden Lötbereich auf. Es handelt sich beim Lötbereich also gewissermassen um einen Streifen, welcher aus der Basis seitlich herausragt. Typischerweise hat ein solcher Streifen eine Breite von circa 0.5 - 5mm, insbesondere bevorzugt von 1 - 3 mm. Dies bei einer Basis mit einer Höhe h im Bereich von 0.2 - 2 mm, insbesondere bevorzugt im Bereich von 0.5 - 1.5 mm, und einer Breite im Bereich von der gleichen Grössenordnung.

Um den Formschluss gewährleisten zu können, verfügt der Lötfuss über einen vertikalen, im Wesentlichen senkrecht zur Ebene der Leiterplatte angeordneten Abschnitt. Dieser ist vollständig in der Basis angeordnet, und an dessen unteren Ende ist der Lötbereich angeordnet.

Insbesondere hinsichtlich einer Stabilisierung der Basis kann es von Vorteil sein, wenn in der Basis eine umlaufende oder im wesentlichen umlaufend und höchstens abschnittsweise unterbrochene Versteifung angeordnet ist, welche bevorzugtermassen in Form einer Lochscheibe ausgebildet ist, deren Ebene parallel zur Ebene der Leiterplatte angeordnet ist. Die Versteifung und der Lötfuss sind vorzugsweise miteinander verbunden oder einstückig ausgebildet. Die Einheit aus Versteifung und Lötfuss ist bevorzugtermassen als Stanz- und Umformteil aus einem metallischen Werkstoff gefertigt.

Gemäss einer weiteren bevorzugten Ausführungsform ist in der Basis ein Löteinsatz eingelassen, welcher eine umlaufende oder umlaufend und höchstens abschnittsweise unterbrochene, im wesentlichen vollständig in der Basis eingelassene Versteifung aufweist, welche bevorzugtermassen in Form einer Lochscheibe ausgebildet ist, deren Ebene parallel zur Ebene der Leiterplatte angeordnet ist, an welcher Versteifung ein vertikaler, im wesentlichen senkrecht zur Ebene der Leiterplatte angeordneter, im wesentlichen vollständig in der Basis eingelassener vertikaler Abschnitt und an diesen anschliessend einen flächiger, auf der Leiterplatte und parallel zu dieser aufliegender Lötbereich angeordnet ist. Dieser Löteinsatz vereint also einerseits die Zurverfügungstellung der Möglichkeit der Befestigung (Lötfüsse) als auch der Versteifung der Basis.

Gemäss einer weiteren bevorzugten Ausführungsform besteht der Tastenkopf wenigstens teilweise aus transparentem oder durchscheinendem Material, und im Tastenkopf ist weiterhin bevorzugtermassen ein Beleuchtungselement, insbesondere ein LED angeordnet. Die Kontaktierung des Beleuchtungselementes kann über wenigstens zwei Lötfüsse erfolgen. In diesem Fall ist insbesondere bevorzugt das Beleuchtungselement mit den zwei Lötfüssen über zwei Kontaktierungselemente (flexibler Draht, flexible Lasche), welche bevorzugtermassen in der Membran eingelassen sind, kontaktiert. So können die Lötfüsse zur Befestigung der Taste und gleichzeitig zur Ansteuerung des Beleuchtungselementes verwendet werden, was den Produktionsprozess von Schaltungsanordnungen wesentlich vereinfacht. Um die beiden Pole des Beleuchtungselementes separat ansteuern zu können, erweist es sich als vorteilhaft, wenn in der Basis eine im wesentlichen umlaufende und nur an zwei Stellen unterbrochene Versteifung angeordnet ist, welche bevorzugtermassen in Form einer Lochscheibe ausgebildet ist, deren Ebene parallel zur Ebene der Leiterplatte angeordnet ist, und wenn die Kontaktierungselemente einen elektrischen Kontakt zwischen dem Beleuchtungselement und der Versteifung erzeugen, indem die beiden Pole die über die beiden voneinander getrennten Bereiche der Versteifung angebunden werden. Mit anderen Worten ist ein Lötfuss mit einem Bereich der Versteifung und einem ersten Kontaktierungselement mit dem ersten Anschluss des Beleuchtungselementes verbunden, und der andere Lötfuss mit dem anderen Bereich der Versteifung und dem zweiten Kontaktierungselement mit dem zweiten Anschluss des Beleuchtungselementes verbunden. So ist es dann beispielsweise besonders von Vorteil, wenn zwei gegenüber angeordnete Lötfüsse angeordnet sind, und wenigstens während der Fertigung wenigstens zwei (in Umfangsrichtung) dazwischen liegende, ebenfalls gegenüber angeordnete Montageverbindungen angeordnet sind, welche vorzugsweise einen Trennspalt aufweisen, welcher zur Unterbrechung der Versteifung in die zwei genannten Bereiche mit unterschiedlicher Polarität führen.

Bei einer derartigen Anschlussmöglichkeit eines Beleuchtungselementes erweist es sich als vorteilhaft, wenn im und/oder auf dem Tastenkopf wenigstens ein Indikator für die Anschlussrichtung des Beleuchtungselementes angeordnet ist (z.B. Vertiefung, Einfärbung etc.).

Für die obigen Anwendungen mit einem (oder mehreren) Beleuchtungselement ist es selbstverständlich zwingend, dass die Lötfüsse und eine gegebenenfalls vorhandene Versteifung respektive die Kontaktierungselemente aus einem elektrisch leitenden Material bestehen oder elektrisch leitfähige Bahnen aufweisen. Bevorzugtermassen bestehen sie aus einem (verzinnten) Metall oder aus einem elektrisch leitenden Kunststoff, wobei Lötfüsse und Versteifung im Fall von Metall insbesondere bevorzugt einstückig in einem Stanz- und Umformprozess gefertigt sind. Die Kontaktierungselemente können an einen derartigen Löteinsatz angelötet (z.B. Wirebonding) oder gekrimpt werden. Mögliche metallische Materialien sind insbesondere Bronze, CuFe3P (z.B. mit Nickelbeschichtung), SAE 1008 etc.

Des Weiteren betrifft die vorliegende Erfindung einen Löteinsatz mit den Merkmalen von Anspruch 10 für eine Taste, wie sie oben beschrieben wird, wobei der Löteinsatz insbesondere bevorzugt die oben beschriebenen Merkmale aufweist.

Zudem betrifft die vorliegende Erfindung eine Zwei- (Reihe) und/oder dreidimensionale (Matte) Anordnung von Tasten von einer Bauweise, wie sie oben beschrieben wird, oder von solchen Löteinsätzen. Bei der Anordnung sind vorzugsweise die Tasten respektive die Löteinsätze über die Lötfüsse und/oder die Montageverbindungen miteinander verbunden und werden bevorzugtermassen erst kurz vor der Montage oder vor dem einbringen in eine Montagevorrichtung in einzelne Tasten aufgetrennt.

Ausserdem betrifft die vorliegende Erfindung ein Verfahren zur Herstellung einer Taste der oben beschriebenen Art oder zur Herstellung einer Anordnung, wie sie oben beschrieben wurde. Das Verfahren ist bevorzugtermassen dadurch gekennzeichnet, dass in einem Spritzgusswerkzeug oder Kompressionswerkzeug die Kontaktpille sowie Lötfüsse oder die ganzen Löteinsätze eingelegt werden, sowie gegebenenfalls ein Beleuchtungselement (vorzugsweise in bereits verbundener, das heisst zusammengelöteter Form) und ggf. Kontaktierungselement(e), und dass anschliessend isolierendes elastisches Material (Silicon) eingespritzt und in der Form wenigstens teilweise verfestigt wird.

Ein solches Verfahren ist bevorzugtermassen dadurch gekennzeichnet, dass eine oben beschriebene Anordnung von Tasten hergestellt wird und diese anschliessend, insbesondere bevorzugt entlang einer Trennkante, welche zur Ausbildung von zwei elektrisch voneinander getrennten Abschnitten der Versteifung führt, voneinander zu Einzeltasten getrennt werden.

Zu guter letzt betrifft die vorliegende Erfindung die Verwendung einer solchen Taste zur Befestigung auf einer Leiterplatte insbesondere unter Zuhilfenahme eines Lötvorganges über die Lötfüsse, insbesondere bevorzugt im Rahmen der SMT-Technologie.

Weitere bevorzugte Ausführungsfonnen sind in den abhängigen Ansprüchen beschrieben.

### KURZE ERLÄUTERUNG DER FIGUREN

Die Erfindung soll nachfolgend anhand von Ausführungsbeispielen im Zusammenhang mit den Zeichnungen näher erläutert werden. Es zeigen:
- Fig. 1: einen SMT Single Key ohne LED, wobei in a) ein zentraler Schnitt in einer Richtung senkrecht zur Ausrichtung der Lötfüsse dargestellt ist, in b) eine Ansicht von oben und in c) ein zentraler Schnitt in einer Richtung parallel zur Ausrichtung der Lötfüsse;
- Fig. 2: einen SMT Single Key mit langem Hub und Kontaktpille sowie Wirebonding von LED, dies in analogen Darstellungen wie in Figur 1;
- Fig. 3: einen SMT Single Key mit kurzem Hub und Metalldom sowie SMT Löten von LED, dies in analogen Darstellungen wie in Figur 1;
- Fig. 4: einen Löteinsatz (SMT Solder Pin), wobei in a) ein zentraler Schnitt in einer Richtung A-A dargestellt ist, in b) eine Ansicht von oben und in c) ein zentraler Schnitt in einer Richtung B-B; und
- Fig. 5: eine Reihe von solchen Löteinsätzen (SMT Solder Pin Array).

### WEGE ZUR AUSFÜHRUNG DER ERFINDUNG

Der SMT Single Key wird im gleichen Verfahren wie eine übliche Schaltmatte in einem Kompressionswerkzeug für Silikonelastomer hergestellt. Im Werkzeug wird zuerst eine elektrisch leitende Kontaktpille eingelegt, dann eine definierte Menge unvulkanisiertes Silikon. Anschliessend wird das Werkzeug geschlossen und das Silikon vulkanisiert bei ca. 170°C während ca. 10 Minuten. Dann wird der ausgeformte Schaltdom dem Werkzeug entnommen, entgratet (entlang definierter Reisskante) und nachgetempert bei 150°C während 2h.

Die Membrane des Schaltdoms ist in Kombination mit den Materialeigenschaften des Silikontyps und des Abstandes der Kontaktpille zur Basis so ausgelegt, dass eine gewünschte Kraft-Weg Kurve beim Betätigen resultiert (taktile Rückmeldung).

Neu hinzu kommt nun der SMT Solder Pin mit 2 Lötfüsschen. Das ist ein Stanz-Biegeteil, welches 3 Funktionen erfüllt:
a) Metallfläche zum ermöglichen einer SMT Montage auf der Leiterplatte (PCB, Printed Cirquit Board). SMT ist die gängige Methode zum Bestücken von Leiterplatten in Gross-Serien.
b) Kontaktfläche zum Anschluss der LED
c) Umlaufende Versteifung der Basis, sodass während der Betätigung das Silikon nicht nachgibt.

Der SMT Solder Pin wird nach der Kontaktpille ins offene Werkzeug eingelegt und dann während dem Vulkanisieren vom Silikon ganz umschlossen (Halterung durch Formschluss). Nach dem Vulkanisieren wird das Teil entgratet. Weil das Silikon nicht auf Metall haftet, wird der Bereich der Lötfüsschen beim Entgraten wieder Silikonfrei gemacht. Dies erfolgt durch exakt positionierte Reisskanten entlang der Materialüberlaufkanäle. Weil das Einlegen von einem einzelnen SMT Solder Pin nicht sehr rationell ist, kann man auch mehrere zusammenhängende SMT Solder Pins in einem Array in mehrere Werkzeugkavitäten einlegen und dann nach dem Vulkanisieren mit einem kleinen Stanzwerkzeug auseinander trennen.

Wenn der SMT Solder Pin mit einem Trennspalt versehen ist, werden durch das Stanzen die beiden Lötfüsschen voneinander elektrisch getrennt. Das ermöglicht wiederum den Anschluss eines elektrischen Bauteils, z.B. einer LED zwischen den beiden Lötfüsschen.

Die LED zur Tastenhinterleuchtung wird auf dem SMT Solder Pin befestigt. Dies kann durch Löten (SMT) an flexible Laschen oder aber bevorzugt durch Drahtbonden gemacht werden. Das Drahtbonden hat den Vorteil, dass die Draht-Verbindung beliebig der Membrangeometrie angepasst werden kann und dass die Drähte sehr flexibel sind und somit die Kraft-Weg Kurve der Taste nicht oder kaum beeinträchtigen. Während dem Vulkanisieren wird dann die LED einfach zusammen mit dem SMT Solder Pin vom transparenten Silikon umflossen und so wasserdicht ins Bauteil integriert. Die Lichtstreuung kann durch Variieren der Tastenkopf-Oberflächenqualität sowie der Materialfarbe eingestellt werden.

Zum Schluss wird das Teil nachgetempert zur Verhinderung von Silikonausgasungen.

Wenn die LED nur in eine Richtung funktioniert, kann am Tastenkopf ein Pfeil oder anderes Symbol für die Anschlussrichtung angebracht werden z.B. durch eine entsprechende Vertiefung im Werkzeug.

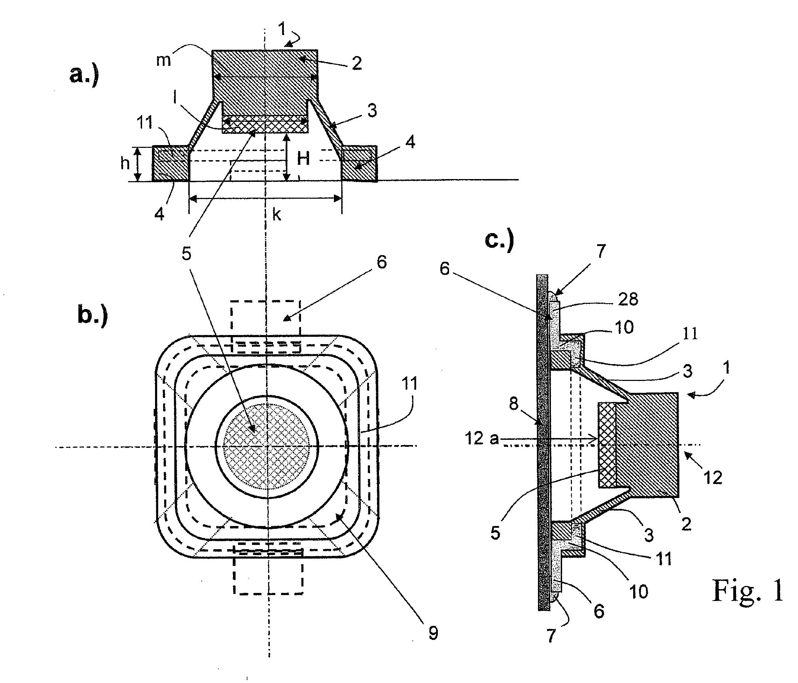

In Figur 1 ist eine solche Einzeltaste 1 in unterschiedlichen Ansichten dargestellt. Die Einzeltaste oder SMT Single Key 1 umfasst einen Tastenkopf 2 sowie eine umlaufende Basis 4. Zwischen der Basis 4 und dem Tasterikopf 2 ist eine ebenfalls umlaufende Membran 3 angeordnet. Basis 4, Membran 3 und Tastenkopf 2 bilden somit den eigentlichen Dom, alle drei Elemente bestehen aus Silikon. Auf der Unterseite 12a des Tastenkopfes 2 ist ein Kontaktelement 5, beispielsweise eine Kontaktpille 5 aus Metall oder leitfähigem Kunststoff, angeordnet.

In der Basis 4 sind nun die verzinnten Lötfüsse 6 formschlüssig verankert. Der Lötbereich 28 davon steht aus der Basis hervor, ein vertikaler Bereich 10 ist vollständig in der Basis 4 eingebettet. Des Weiteren ist in der Basis eine Versteifung 11 angeordnet, welche in diesem Fall als Lochscheibe ausgebildet ist, und welche umlaufend in der gesamten Basis eingebettet ist.

Eine derartige Taste 1 wird über zwei Lötstellen 7 auf der Leiterplatte 8 befestigt. Zum Abführen gegebenenfalls unterhalb des Doms entstehender Wärme kann es von Vorteil sein, wenn in diagonaler Richtung über Entlüftungskanäle heisse Luft abgeführt respektive kühle Luft zugeführt werden kann. Die Entlüftungskanäle sind aber auch entscheidend, um den Abfluss von Luft beim Pressen und ein Ansaugen von Luft beim Loslassen der Taste in den Bereich unterhalb der Taste zu erlauben. Werden diese Entlüftungskanäle oder entsprechende Mittel (es sind auch Löcher in der Membran denkbar) nicht vorhanden, so lässt sich die Taste wegen der unterhalb eingeschlossenen Luft nicht herunter drücken respektive eine einmal herunter gedrückte Taste entspannt sich nicht oder nur sehr langsam.

Eine solche Taste besitzt normalerweise eine Gesamthöhe im Bereich von 2-5 mm, bevorzugtermassen im Bereich von 3 bis 4 mm. Der Abstand H zwischen der Leiterplatte 8 und der Unterseite der Kontaktpille 5 beträgt normalerweise circa 1-2 mm, und gegenüberliegende Schenkel der Basis 4 haben einen Abstand k im Bereich von 3-8 mm, bevorzugtermassen im Bereich von 4-5 mm. Der Tastenkopf 2 kann rund ausgebildet sein und hat dann beispielsweise einen Durchmesser m im Bereich von 2-4 mm. Eine Kontaktpille 5 ist normalerweise kreisrund oder quadratisch ausgebildet und hat einen Durchmesser 1 im Bereich von 2-3 mm. Die Lötbereiche 28 stehen wenigstens 0.5 mm seitlich über die Basis hinaus, bevorzugt im Bereich von 0.5 mm-2 mm.

Das Blech, aus welchem die Lötfüsse und die Versteifung (einstückig in einem Stanz- und Umformverfahren) hergestellt werden, hat normalerweise eine Dicke im Bereich von 0.2-0.5 mm. Die Versteifung 11 ist vollständig im Material der Basis 4 eingebettet und tritt nirgends aus der Basis 4 heraus. Der vertikale Bereich 10 ist bevorzugtermassen ebenfalls vollständig in der Basis 4 eingebettet, kann aber auch nach unten zur Leiterplatte, wie dies in Figur 1 erkannt werden kann, teilweise freiliegen.

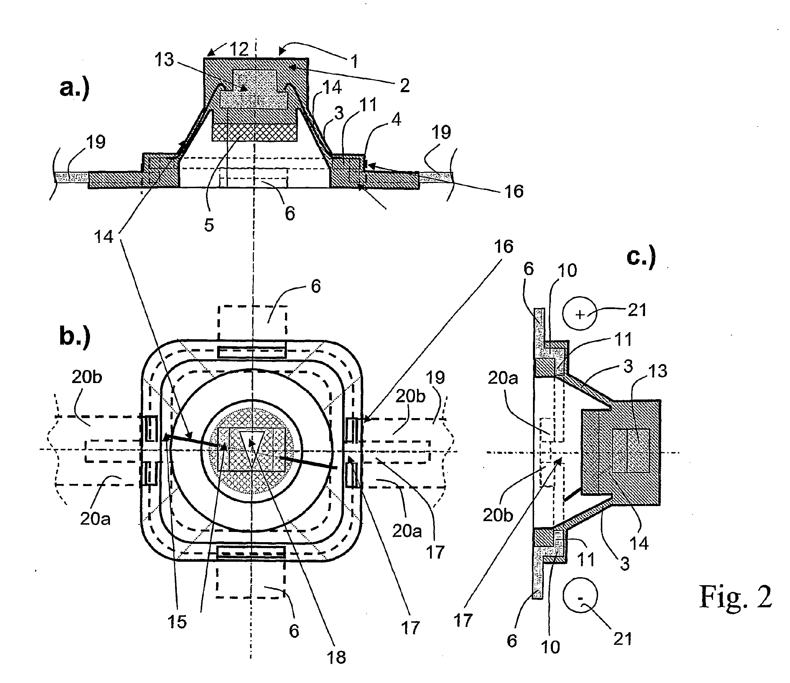

In Figur 2 ist ein SMT Single Key mit langem Hub und Kontaktpille und Wirebonding von LED dargestellt. Ein LED 13 ist in Tastenkopf 2 integriert. In diesem Fall dienen die beiden Lötfüsse 6 dazu, das LED 13 anzusteuern. Zu diesem Zweck ist die Versteifung 11 in zwei Bereiche aufgeteilt, welche unterschiedliche' Polarität 21 aufweisen. Das LED 13 ist über einen ersten flexiblen Draht 14 mit dem Bereich mit erster Polarität verbunden, und der zweite Anschluss des LED 13 ist über einen zweiten flexiblen Draht 14 mit dem anderen Bereich mit zweiter Polarität verbunden. Die Verbindung zwischen dem flexiblen Draht 14 und der Versteifung sowie zwischen dem flexiblen Draht 14 und dem LED 13 kann eine vergoldete Lötstelle für Wirebonding sein. Die beiden Bereiche der Versteifung 11 sind über einem Trennspalt 17 elektrisch voneinander getrennt. In Figur 2 ist dabei die Situation unmittelbar nach der Herstellung dargestellt, bei welcher die beiden Bereiche noch miteinander verbunden sind. Zur Vereinfachung der Herstellung wird nämlich die Versteifung mit zwei lateral angebundenen Montageverbindungen 19, welche ebenfalls einen Trennspalt 17 aufweisen, vorgelegt. Vor der (End-)Montage wird bei der Trennkante 16 abgetrennt und so die beiden Arme 20a und 20b durchtrennt und damit die beiden Bereiche der Versteifung 11 elektrisch voneinander getrennt. Die beiden Bereiche der Versteifung 11 sind getrennt voneinander mit den zwei gegenüberliegenden Lötfüssen 6 an entsprechende Leiterbahnen auf der Leiterplatte anzuschliessen.

Der Abstand zwischen der Unterseite der Montageverbindungen 19 zur Leiterplatte sollte wenigstens 0.2 Millimeter betragen (der Zwischenraum ist über Silikon isoliert), damit ein Kurzschluss zur Leiterplatte vermieden werden kann.

Da normalerweise ein LED eine vorgegebene Anschlussrichtung hat, erweist es sich als vorteilhaft, wenn ein Indikator 18 beispielsweise auf dem Tastenkopf angeordnet ist.

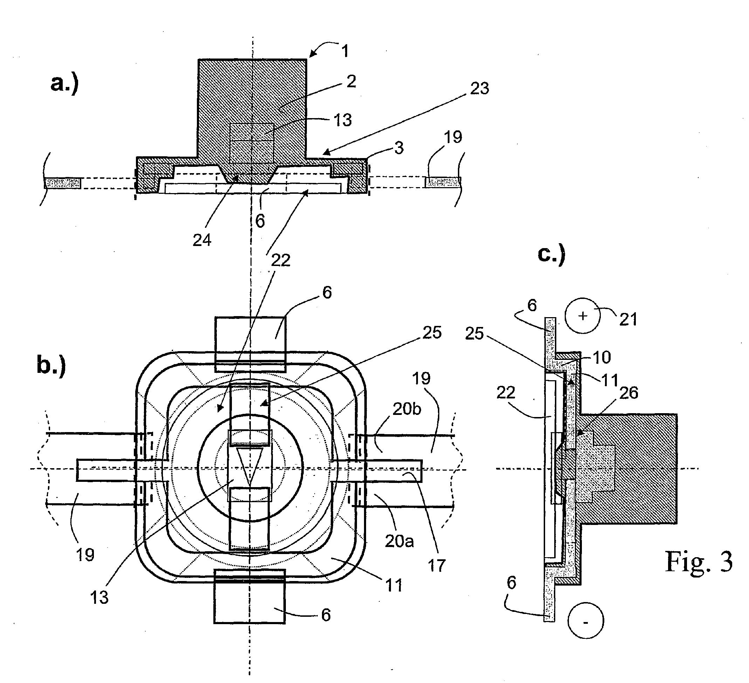

In Figur 3 ist ein SMT Single Key mit kurzem Hub und Metalldom und SMT Löten von LED dargestellt. In diesem Fall ist die Membran eine Flachmembran 23, und der Tastenkopf 2 verfügt auf seiner Unterseite über einen Betätigungsstössel 24, welcher auf einen Metalldom 22 einwirkt. Das im Tastenkopf 2 angeordnete LED ist über zwei flexible Laschen 25 an die zwei Bereiche der Versteifung angeschlossen. Die beiden jeweiligen Verbindungen der flexiblen Laschen können über SMT-Lötstellen 26 gegeben sein.

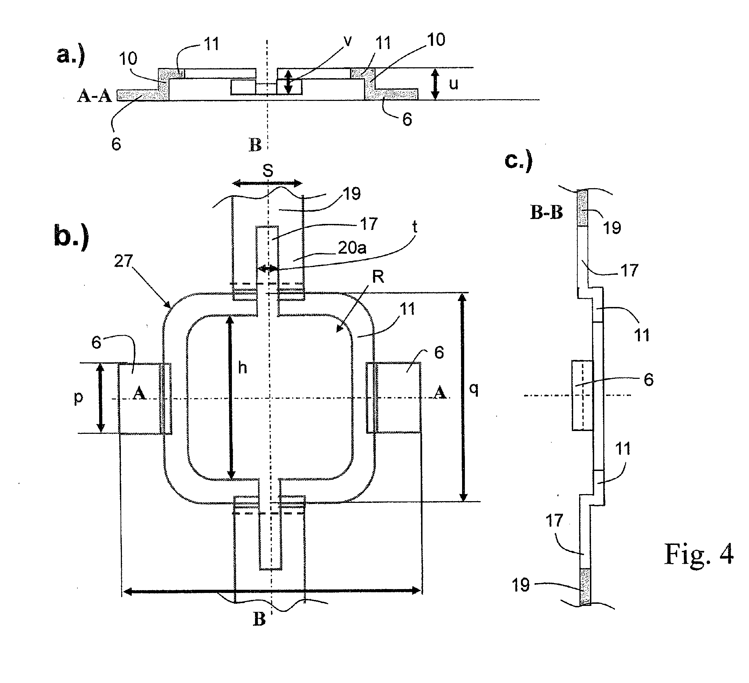

In Figur 4 ist ein SMT Solder Pin dargestellt, das heisst ein Bauteil, welches als Stanz- und Biegeteil hergestellt werden kann und in eine Form eingelegt werden kann. Es umfasst die Versteifung 11, die Lötfüsse 6 sowie die Montageverbindungen 19. In dieser Figur kann erkannt werden, dass die Lötfüsse 6 eine Breite p im Bereich von 1-3 mm aufweisen, und die Montageverbindungen 19 eine Breite ebenfalls im Bereich von 1-3 mm. Der Abstand zwischen den beiden Armen 20a und 20b beträgt bevorzugter Weise wenigstens 0.5mm. Die Versteifung ist abgerundet quadratisch (mit einer Rundung R von circa 0.5 Millimeter) und verfügt über eine äussere Breite von 5-7mm.

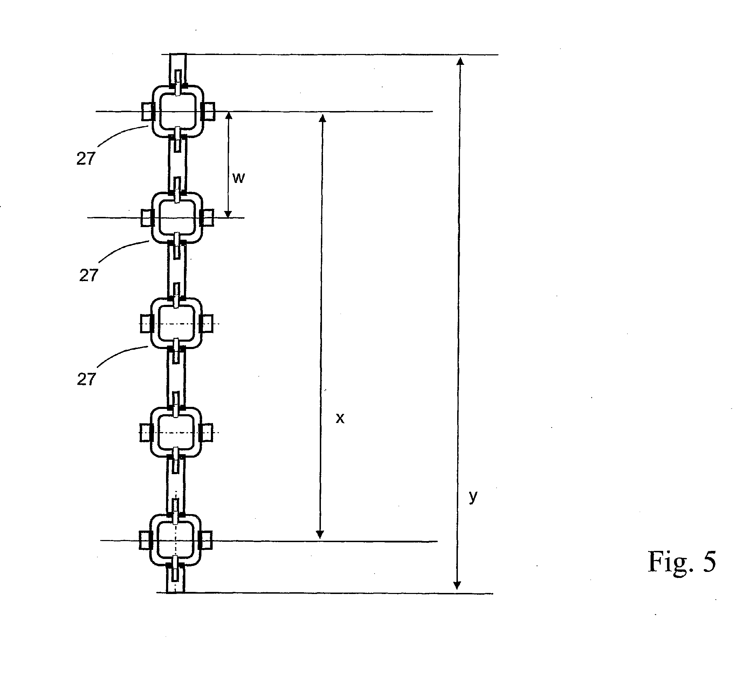

Vorteilhafter Weise werden derartige Solder pins oder Löteinsätze als SMT Solder Pin Array hergestellt, wie sie in Figur 5 dargestellt sind, das heisst die einzelnen Löteinsätze sind in einer Kette oder sogar in einer Matrix über die Montageverbindungen 19 und/oder die Lötfüsse 6 miteinander verbunden. Die Abmessungen w, x, y können dabei 12, 48 resp. 60 mm betragen. Diese SMT Solder Pins können also in einer Reihe oder unendlich angeordnet sein (beispielsweise auf Rolle). Stanzen nach Vulkanisation.

### Spezifische Ausführungen:

Kurzer Hub 0.2 mm - 0.8 mm (Metalldom macht beliebig wählbare Kraft-Weg Kurve und elektrischen Kontakt)
Langer Hub 0.8mm -3mm (Silikonmembrane macht beliebig wählbare Kraft-Weg Kurve, Kontaktpille macht elektrischen Kontakt)

### Mit oder ohne LED

### Spezifische Varianten:

Kontaktpille: Alle gängigen Kontaktpillen können verwendet werden wie Karbonpille, Goldpille, SC Pille oder auch Leitlack. Die Wahl der Kontaktpille hängt von den elektrischen Anforderungen an den Schaltdom ab. Der Pillendurchmesser muss der Teilegrösse angepasst sein (z.B. 2.5mm)
Metalldom: Der Metalldom kann eine Geometrie wie z.B. rund oder 4-leg haben. Die Wahl des Metalldomes hängt von den Kraft-Weg Anforderungen an den Schaltdom ab. Der Domdurchmesser muss der Teilegrösse angepasst sein (z.B. 5.0mm).

Der Metalldom kann entweder durch Verkleben mit dem Betätigungsstössel oder mittels einer üblichen Klebefolie an die untere Basis angebracht werden, dies normalerweise als letzter Prozessschritt. Ebenfalls möglich ist es, Metalldome mit dafür angeformten Befestigungsfüsschen an der Basis fest zu kleben. Hersteller von solchen Metalldomen sind z.B. Nicomatic in Europa, Snaptron in USA oder Truetone in Asien um nur einige zu nennen.
Kraft-Weg Kurve: Durch Auslegung der richtigen Membrangeometrie respektive des Metalldomes in Kombination mit den Silikoneigenschaften kann fast jede beliebige Kurve nach Kundenvorgabe realisiert werden.
Bauteilhöhe: Der Tastenkopf kann beliebig hoch gestaltet werden.
LED: Es kann eine handelsübliche LED verwendet werden, zu beachten ist einzig die Einbaugrösse und Eignung zum SMT Löten oder Wirebonden (Anordnung und Qualität der Lötflache). Dabei können Farbe, Helligkeit, Abstrahlwinkel etc. aus einer Palette ausgewählt werden. Beispiel Kingbright Chip-LED 0805, superhell mit Abmessung 2mm x 1.25mm x 1.1mm. Es ist auch denkbar, einen allfälligen Vorwiderstand zu integrieren.

### LED Befestigung:

Drahtbonden: Mit einem Wirebonder kann eine flexible Verbindung zwischen SMT Solder Pin und LED hergestellt werden. Dabei gibt es Gold oder Aluminiumdrähte in unterschiedlichen Dicken. Bewährt hat sich z.B. Golddraht mit einer Dicke im Bereich von 30 - 150 µm, als besonders vorteilhaft hat sich bei Golddraht eine Dicke im Bereich von 100 µm erwiesen.
SMT Löten: Die LED kann bei der Metalldomausführung direkt auf dem SMT Solder Pin aufgelötet werden, wenn dieser mit 2 flexiblen Laschen versehen ist, da hier nur ein kleiner Hub in einer Flachmembrane zu bewältigen ist.

### SMT Solder pin:

Der SMT Solder Pin ist als Stanz-Biegeteil ausgelegt, ein leitfähiges Kunststoffteil ist aber auch möglich (3D-MID Moulded Interconnect Devices).

Material ist bevorzugt CuFe3P mit einer 2µm dicken Nickelbeschichtung (Ni), kann aber auch z.B. Bronze oder rostfreier Stahl (SAE 1008) sein.

Der Lötfüsschen-Bereich ist bevorzugt verzinnt (Sn) für ein problemloses bleifreies SMT Löten auf die Leiterplatte.

Der Bereich für das Drahtbonden (Wirebonding) wird idealerweise mit 0.2µm Gold (Au) beschichtet für eine einwandfreie Haftung.

Der SMT Solder Pin kann als Einzelteil oder in Reihe zusammenhängend als Array vorliegen, z.B. mit Trennspalt für elektrische Trennung.

Tastenkopf: Transparentes Silikon oder milchig eingefärbtes Silikon (Diffusion des Lichtes). Polierte oder raue Oberfläche (Diffusion des Lichtes). Bei polierter Oberfläche ist das Silikon klar wie Glas.

### Produktionsverfahren:

Das Teil wird bevorzugt im compression moulding hergestellt, es ist aber auch im Transfer moulding möglich.

Bei hohen Stückzahlen ist ein vollautomatisiertes Liquid Injection Moulding (LIM) mit Liquid Silicone Rubber (LSR / Flüssigsilikon) sinnvoll.

### Vorteile:

- sehr kostengünstig da wenige Bauteile und einfaches Verfahren;
- automatische Bestückung mittels SMT, Anlieferung auf Rollen;
- mit integrierter LED zur Hinterleuchtung als Option;
- in Tastenkopf integrierte LED bringt Licht dort hin, wo es gebraucht wird, für langen Hub ist das absolute Neuheit;
- LED und Taste werden in einem Arbeitsgang auf Leiterplatte montiert, das spart einen Montagevorgang;
- LED ist geschützt vor Umwelteinflüssen;
- kleinste Baugrösse;
- sehr variabel, kundenspezifische Lösung einfach möglich;
- sowohl mit kurzem Hub 0.2mm-0.8mm (Metalldom) als auch mit langem Hub 0.8mm-3mm (Schaltmatte);
- grosse Auswahl an Kraft-Weg Kennlinien (auf Kundenbedürfnis abgestimmt);
- viele Kontaktpillen möglich;
- 1 System für alle Anforderungen;
- keine losen Teile da SMT Solder Pin und LED direkt in Bauteil eingebettet sind;
- Temperaturbereich -40°C - +110°C

### Anwendungen (Beispiele):

- Als Taste/Schalter für jedes Eingabegerät wo eine Taste über eine Kunststoffkappe betätigt wird;
- ersetzt heutige Schaltmatten z.B. für Eingabegeräte im Automobil (Fensterheber, Spiegelversteller, Radio);
- ersetzt konventionelle Tact Switches weil LED gleich integriert und weil billiger.

### BEZUGSZEICHENLISTE

- 1: Einzeltaste
- 2: Tastenkopf.
- 3: Membrane
- 4: Basis
- 5: Kontaktelement, Kontaktpille
- 6: (verzinnter) Lötfuss
- 7: Lötstelle
- 8: Leiterplatte (PCB)
- 9: Entlüftungskanal
- 10: vertikaler Abschnitt von 6
- 11: (umlaufende) Versteifung
- 12: Oberseite von 2
- 12a: Unterseite von 2
- 13: LED
- 14: flexibler Draht
- 15: vergoldete Lötstelle
- 16: Trennkante
- 17: Trennspalt
- 18: Indikator für Anschlussrichtung
- 19: Montageverbindung
- 20a/b: Arme von 19
- 21: Anschlusspolarität
- 22: Metalldom
- 23: Flachmembran
- 24: Betätigungsstössel
- 25: flexible Lasche
- 26: Lötstelle
- 27: Löteinsatz, Solder Pin
- 28: Lötbereich
- h: Höhe von 4
- H: Abstand zwischen 5 und 8
- k: Abstand zwischen Schenkeln von 4
- 1: Durchmesser/Breite von 5
- m: Durchmesser/Breite von 2
- n: innerer Abstand zwischen Schenkeln von 11
- p: Breite von 6
- q: äusserer Abstand zwischen Schenkeln von 11
- R: Radius
- s: Breite von 19
- t: Breite von 17
- u: Höhe von 10
- v: Dicke von 19
- w,x,y: Abstände

## Patentansprüche

1. Taste (1) zur intermittierenden elektrischen Kontaktierung wenigstens zweier, auf einer Leiterplatte (8) angeordneter Leiter mit einem elektrisch leitenden Kontaktelement (5,22), wobei die Taste (1) wenigstens eine auf der Leiterplatte (8) angeordnete Basis (4) sowie einen bezüglich der Leiterplatte (8) und der Basis (4) beweglichen Tastenkopf (2) mit dem Kontaktelement (5) oder ein darunter angeordnetes Kontaktelement (22) aufweist, wobei der Tastenkopf (2) über wenigstens eine bewegliche Membran (3) mit der Basis (4) verbunden ist, und wobei Basis (4) und Membran (3) aus einem isolierenden elastischen Material bestehen, wobei die Taste (1) zusätzlich wenigstens einen Lötfuss (6) aufweist, welcher mit seinem ersten Ende formschlüssig in der Basis (4) eingelassen ist und mit dessen zweitem Ende, dem Lötbereich (28), die Taste (1) auf der Leiterplatte (8) befestigt werden kann,
**dadurch gekennzeichnet, dass**
der Lötfuss (6) einen flächigen, auf der Leiterplatte (8) und parallel zu dieser aufliegenden Lötbereich (28) aufweist, und der Lötfuss (6) einen vertikalen, im wesentlichen senkrecht zur Ebene der Leiterplatte (8) angeordneten Abschnitt (10) aufweist, welcher vollständig in der Basis (4) angeordnet ist, und an dessen unteren Ende der Lötbereich (28) angeordnet ist.

2. Taste (1) nach Anspruch 1, **dadurch gekennzeichnet, dass** zwei auf gegenüberliegenden Seiten der Taste angeordnete Lötfüsse (6) angeordnet sind.

3. Taste (1) nach einem der vorhergehenden Ansprüche, **dadurch gekennzeichnet, dass** die Basis (4) als auf der Leiterplatte (8) um die Position der zu kontaktierenden Leiter umlaufendes Element ausgebildet ist, aus welchem der wenigstens eine Lötfuss (6) seitlich herausragt.

4. Taste (1) nach einem der vorhergehenden Ansprüche, **dadurch gekennzeichnet, dass** in der Basis (4) eine umlaufende oder höchstens umlaufend und abschnittsweise unterbrochene Versteifung (11) angeordnet ist, welche bevorzugtermassen in Form einer Lochscheibe ausgebildet ist, deren Ebene parallel zur Ebene der Leiterplatte (8) angeordnet ist, wobei die Versteifung (11) und der Lötfuss (6) vorzugsweise miteinander verbunden sind oder einstückig ausgebildet sind.

5. Taste (1) nach einem der vorhergehenden Ansprüche, **dadurch gekennzeichnet, dass** in der Basis ein Löteinsatz (27) eingelassen ist, welcher eine umlaufende oder höchstens umlaufend und abschnittsweise unterbrochene, im wesentlichen vollständig in der Basis (4) eingelassene Versteifung (11) aufweist, welche bevorzugtermassen in Form einer Lochscheibe ausgebildet ist, deren Ebene parallel zur Ebene der Leiterplatte (8) angeordnet ist, an welcher Versteifung (11) ein vertikaler, im wesentlichen senkrecht zur Ebene der Leiterplatte (8) angeordneter, im wesentlichen vollständig in der Basis (4) eingelassener Abschnitt (10) und an diesen anschliessend einen flächiger, auf der Leiterplatte (8) und parallel zu dieser aufliegender Lötbereich (28) angeordnet ist.

6. Taste (1) nach einem der vorhergehenden Ansprüche, **dadurch gekennzeichnet, dass** der Tastenkopf (2) wenigstens teilweise aus transparentem oder durchscheinendem Material besteht, und dass im Tastenkopf (2) ein Beleuchtungselement, insbesondere bevorzugt ein LED (13) angeordnet ist, welches bevorzugtermassen vom Material des Tastenkopfes (2) vollständig umschlossen ist wobei die Kontaktierung des Beleuchtungselementes (13) vorzugsweise über wenigstens einen, bevorzugt zwei Lötfüsse (6) erfolgt, und wobei das Beleuchtungselement (13) mit den zwei Lötfüssen (6) über zwei Kontaktierungselemente (14, 25), welche bevorzugtermassen in der Membran (3) eingelassen sind, kontaktiert wird, und in der Basis (4) eine umlaufende und an zwei Stellen unterbrochene Versteifung (11) angeordnet ist, welche bevorzugtermassen in Form einer Lochscheibe ausgebildet ist, deren Ebene parallel zur Ebene der Leiterplatte (8) angeordnet ist, und dass die Kontaktierungselemente (14, 25) einen elektrischen Kontakt zwischen dem Beleuchtungselement (13) und der Versteifung (11) erzeugen.

7. Taste (1) nach Anspruch 6, **dadurch gekennzeichnet, dass** zwei gegenüber angeordnete Lötfüsse (6) angeordnet sind, und dass wenigstens während der Fertigung wenigstens zwei dazwischen liegende, ebenfalls gegenüber angeordnete Montageverbindungen (19) angeordnet sind, welche vorzugsweise einen Trennspalt (17) aufweisen, welche zur Unterbrechung der Versteifung (11) führen.

8. Taste (1) nach einem der vorhergehenden Ansprüche, **dadurch gekennzeichnet, dass** im und/oder auf dem Tastenkopf (2) wenigstens ein Indikator (18) für die Anschlussrichtung des Beleuchtungselementes (13) angeordnet ist.

9. Taste (1) nach einem der vorhergehenden Ansprüche, **dadurch gekennzeichnet, dass** die Lötfüsse (6) und die Versteifung (11) aus einem elektrisch leitenden Material, insbesondere bevorzugt aus einem Metall bestehen, wobei sie insbesondere bevorzugt einstückig in einem Stanz- und Umformprozess gefertigt sind.

10. Löteinsatz (27) für eine Taste (1) nach Anspruch 5, welcher eine umlaufende oder höchstens umlaufend und abschnittsweise unterbrochene, im wesentlichen vollständig in der Basis (4) eingelassene Versteifung (11) aufweist, welche in Form einer Lochscheibe ausgebildet ist, deren Ebene parallel zur Ebene der Leiterplatte (8) angeordnet ist, an welcher Versteifung (11) ein vertikaler, im wesentlichen senkrecht zur Ebene der Leiterplatte (8) angeordneter, im wesentlichen vollständig in der Basis (4) eingelassener Abschnitt (10) und an diesen anschliessend einen flächiger, auf der Leiterplatte (8) und parallel zu dieser aufliegender Lötbereich (28) angeordnet ist.

11. Zwei- und/oder dreidimensionale Anordnung von Tasten (1) nach einem der Ansprüche 1-9 oder von Löteinsätzen (27) nach Anspruch 10, bei welcher die Tasten (1) respektive die Löteinsätze (27) über die Lötfüsse (6) und/oder die Montageverbindungen (19) miteinander verbunden sind.

12. Verfahren zur Herstellung einer Taste nach einem der Ansprüche 1-9 oder zur Herstellung einer Anordnung nach Anspruch 11, **dadurch gekennzeichnet, dass** in einem Spritzgusswerkzeug oder Kompressionswerkzeug die Kontaktpille sowie die Lötfüsse (6) oder die Löteinsätze (27) eingelegt werden, sowie gegebenenfalls ein Beleuchtungselement (13) und Kontaktierungselemente (14, 25), und dass anschliessend isolierendes elastisches Material eingespritzt und in der Form wenigstens teilweise verfestigt wird.

13. Verfahren nach Anspruch 12, **dadurch gekennzeichnet, dass** eine Anordnung nach Anspruch 11 hergestellt wird und diese anschliessend, insbesondere bevorzugt entlang einer Trennkante (16), welche zur Ausbildung von zwei elektrisch voneinander getrennten Abschnitten der Versteifung (11) führt, voneinander zu Einzeltasten getrennt werden.

14. Verwendung einer Taste nach einem der Ansprüche 1-9 zur Befestigung auf einer Leiterplatte (8) insbesondere unter Zuhilfenahme eines Lötvorganges über die Lötfüsse (6), insbesondere bevorzugt im Rahmen der SMT-Technologie.

## Claims

1. A key (1) for intermittent electrical contact-connection of at least two conductors arranged on a printed circuit board (8) to an electrically conductive contact element (5, 22), wherein the key (1) has at least one base (4) arranged on the printed circuit board (8) and also a key head (2) - which is movable relative to the printed circuit board (8) and the base (4) - with the contact element (5), or a contact element (22) arranged underneath, wherein the key head (2) is connected to the base (4) by means of at least one movable membrane (3), and wherein base (4) and membrane (3) are composed of an insulating elastic material, wherein the key (1) additionally has at least one soldering foot (6) which is incorporated by the first end thereof in the base (4) in a positively locking manner and by the second end of which, the soldering region (28), the key (1) can be fixed on the printed circuit board (8),
**characterized in that**
the soldering foot (6) has a planar soldering region (28) bearing on the printed circuit board (8) and parallel thereto the soldering foot (6) has a vertical section (10) which is arranged substantially perpendicular to the plane of the printed circuit board (8) and which is arranged completely in the base (4) and at the lower end of which the soldering region (28) is arranged.

2. The key (1) as claimed in claim 1, **characterized in that** two soldering feet (6) are arranged, which are arranged on opposite sides of the key.

3. The key (1) as claimed in any of the preceding claims, **characterized in that** the base (4) is embodied as an element which, on the printed circuit board (8), runs around the position of the conductors to be contact-connected and from which the at least one soldering foot (6) projects laterally.

4. The key (1) as claimed in any of the preceding claims, **characterized in that** a circumferential or at most circumferentially and sectionally interrupted stiffening (11) is arranged in the base (4), said stiffening preferably being embodied in the form of a perforated disk whose plane is arranged parallel to the plane of the printed circuit board (8) the stiffening (11) and the soldering foot (6) are preferably connected to one another or are formed in one piece.

5. The key (1) as claimed in any of the preceding claims, **characterized in that** a soldering insert (27) is incorporated in the base, said soldering insert having a circumferential or at most circumferentially and sectionally interrupted stiffening (11) which is incorporated substantially completely in the base (4) and which is preferably embodied in the form of a perforated disk whose plane is arranged parallel to the plane of the printed circuit board (8), at which stiffening (11) there are arranged a vertical section (10) which is arranged substantially perpendicular to the plane of the printed circuit board (8) and which is incorporated substantially completely in the base (4), and, adjacent to said section, a planar soldering region (28) bearing on the printed circuit board (8) and parallel thereto.

6. The key (1) as claimed in any of the preceding claims, **characterized in that** the key head (2) is at least partly composed of transparent or translucent material, and **in that** there is arranged in the key head (2) an illumination element, in particular preferably an LED (13), which is preferably completely enclosed by the material of the key head (2), wherein the contact-connection of the illumination element (13) preferably is effected by means of at least one, preferably two soldering feet (6), and wherein the illumination element (13) is contact-connected to the two soldering feet (6) by means of two contact-connection elements (14, 25) which are preferably incorporated in the membrane (3), and a circumferential stiffening (11) interrupted at two locations is arranged in the base (4), said stiffening preferably being embodied in the form of a perforated disk whose plane is arranged parallel to the plane of the printed circuit board (8), and **in that** the contact-connection elements (14, 25) produce an electrical contact between the illumination element (13) and the stiffening (11).

7. The key (1) as claimed in claim 6, **characterized in that** two oppositely arranged soldering feet (6) are arranged, and **in that**, at least during production, at least two intervening, likewise oppositely arranged mounting connections (19) are arranged, which preferably have a separating gap (17), which lead to the interruption of the stiffening (11).

8. The key (1) as claimed in any of the preceding claims, **characterized in that** at least one indicator (18) for the connecting direction of the illumination element (13) is arranged in and/or on the key head (2).

9. The key (1) as claimed in any of the preceding claims, **characterized in that** the soldering feet (6) and the stiffening (11) are composed of an electrically conductive material, in particular preferably of a metal, wherein they are produced in particular preferably in one piece in a stamping and forming process.

10. A soldering insert (27) for a key (1) as claimed in claim 5, comprising a circumferential or at most circumferentially and sectionally interrupted stiffening (11) in the base (4), said stiffening being embodied in the form of a perforated disk whose plane is arranged parallel to the plane of the printed circuit board (8), at which stiffening (11) there are arranged a vertical section (10) which is arranged substantially perpendicular to the plane of the printed circuit board (8) and which is incorporated substantially completely in the base (4), and, adjacent to said section, a planar soldering region (28) bearing on the printed circuit board (8) and parallel thereto.

11. A two- and/or three-dimensional arrangement of keys (1) as claimed in any of claims 1-9 or of soldering inserts (27) as claimed in claim 10, wherein the keys (1) or the soldering inserts (27), respectively, are connected to one another by means of the soldering feet (6) and/or the mounting connections (19).

12. A method for producing a key as claimed in any of claims 1-9 or for producing an arrangement as claimed in claim 11, **characterized in that** the contact pellet and also the soldering feet (6) or the soldering inserts (27), and also if appropriate an illumination element (13) and contact-connection elements (14, 25), are introduced in an injection mold or compression mold, and **in that** insulating elastic material is subsequently injected and is at least partly solidified in the mold.

13. The method as claimed in claim 12, **characterized in that** an arrangement as claimed in claim 16 is produced and these are subsequently separated from one another to form single keys, in particular preferably along a separating edge (16) which leads to the formation of two sections of the stiffening (11) which are electrically isolated from one another.

14. The use of a key as claimed in any of claims 1-9 for fixing on a printed circuit board (8) in particular with the aid of a soldering operation by means of the soldering feet (6), in particular preferably in the context of SMT technology.

## Revendications

1. Touche (1) pour la mise en contact électrique intermittente d'au moins deux conducteurs disposés sur une carte de circuits imprimés (8) avec un élément de contact électroconducteur (5, 22), la touche (1) présentant au moins une base (4) disposée sur la carte de circuits imprimés (8) ainsi qu'une tête de touche (2) mobile par rapport à la carte de circuits imprimés (8) et à la base (4) avec l'élément de contact (5) ou bien un élément de contact (22) disposé en-dessous, la tête de touche (2) étant reliée via au moins une membrane mobile (3) à la base (4), et la base (4) et la membrane (3) se composant d'une matière élastique isolante, la touche (1) présentant de manière supplémentaire au moins un pied de soudure (6), lequel est noyé avec sa première extrémité par complémentarité de forme dans la base (4) et avec la deuxième extrémité duquel, la zone de soudure (28), il est possible de fixer la touche (1) sur la carte de circuits imprimés (8),
**caractérisée en ce que**
le pied de soudure (6) présente une zone de soudure (28) en nappe, reposant sur la carte de circuits imprimés (8) et parallèlement à celle-ci, et **en ce que** le pied de soudure (6) présente un tronçon (10) vertical, disposé essentiellement perpendiculairement au plan de la carte de circuits imprimés (8), lequel est entièrement mis en place dans la base (4), et à l'extrémité inférieure duquel la zone de soudure (28) est disposée.

2. Touche (1) selon la revendication 1, **caractérisée en ce que** l'on met en place deux pieds de soudure (6) disposés sur des côtés situés en vis-à-vis de la touche.

3. Touche (1) selon l'une des revendications précédentes, **caractérisée en ce que** la base (4) est réalisée en tant qu'élément circulaire autour de la position des conducteurs à contacter sur la carte à circuits imprimés (8), duquel cet au moins un pied de soudure (6) dépasse latéralement.

4. Touche (1) selon l'une des revendications précédentes, **caractérisée en ce que** dans la base (4), un renforcement (11) circulaire ou bien tout au plus circulaire et interrompu par intermittence est disposé, lequel est de préférence réalisé sous forme de disque perforé dont le plan est disposé parallèlement au plan de la carte de circuits imprimés (8), moyennant quoi le renforcement (11) et le pied de soudure (6) sont de préférence reliés ensemble ou bien réalisés d'une seule pièce.

5. Touche (1) selon l'une des revendications précédentes, **caractérisée en ce qu'**un empiècement de soudure (27) est noyé dans la base, lequel présente un renforcement (11) circulaire ou bien tout au plus circulaire et interrompu par intermittence, essentiellement entièrement noyé dans la base (4), lequel est de préférence réalisé sous forme d'un disque perforé dont le plan est disposé parallèlement au plan de la carte de circuits imprimés (8), sur lequel renforcement (11) est disposé un tronçon (10) vertical essentiellement disposé perpendiculaire au plan de la carte de circuits imprimés (8), essentiellement entièrement noyé dans la base (4) et en jonction duquel est disposée une zone de soudure (28) en nappe, reposant sur la carte de circuits imprimés (8) et parallèlement à celle-ci.

6. Touche (1) selon l'une des revendications précédentes, **caractérisée en ce que** la tête de touche (2) se compose au moins partiellement d'une matière transparente ou translucide, et **en ce que** dans la tête de touche (2) est disposé un élément d'éclairage, en particulier de préférence une DEL (13), laquelle est de préférence entièrement entourée par la matière de la tête de touche (2) moyennant quoi la mise en contact de l'élément d'éclairage (13) s'effectue de manière préférée via un pied de soudure (6), de préférence deux pieds de soudure (6), et moyennant quoi le contact est établi avec l'élément d'éclairage (13) avec les deux pieds de soudure (6) via deux éléments de contact (14, 25), lesquels sont de préférence noyés dans la membrane (3), et un renforcement (11) circulaire et interrompu en deux endroits étant disposé dans la base (4), lequel est de préférence réalisé sous la forme d'un disque perforé dont le plan est disposé parallèlement au plan de la carte de circuits imprimés (8), et **en ce que** les éléments de contact (14, 25) établissent un contact électrique entre l'élément d'éclairage (13) et le renforcement (11).

7. Touche (1) selon la revendication 6, **caractérisée en ce que** deux pieds de soudure (6) disposés en vis-à-vis sont disposés, et **en ce qu'**au moins pendant la fabrication, au moins deux liaisons de montage (19) intercalées, également disposées en vis-à-vis, sont disposées, lesquelles présentent de préférence une fente de séparation (17), lesquelles produisent l'interruption du renforcement (11).

8. Touche (1) selon l'une des revendications précédentes, **caractérisée en ce que** dans et/ou sur la tête de touche (2), au moins un indicateur (18) pour la direction de connexion de l'élément d'éclairage (13) est disposée.

9. Touche (1) selon l'une des revendications précédentes, **caractérisée en ce que** les pieds de soudure (6) et le renforcement (11) se composent d'une manière électroconductrice, en particulier de préférence d'un métal, moyennant quoi ils sont fabriqués en particulier de préférence d'une seule pièce lors d'un processus de découpage et de déformation.

10. Empiècement de soudure (27) pour une touche (1) selon la revendication 5, lequel présente un renforcement (11) circulaire ou bien tout au plus circulaire et interrompu par intermittence, essentiellement entièrement noyé dans la base (4), lequel est réalisé sous la forme d'un disque perforé dont le plan est disposé parallèlement au plan de la carte de circuits imprimés (8), contre lequel renforcement (11) un tronçon (10) vertical, essentiellement disposé perpendiculairement au plan de la carte de circuits imprimés (8) est essentiellement complètement noyé dans la base (4), et une zone de soudure (28) en nappe en jonction avec celui-ci reposant sur la carte de circuits imprimés. (8) et parallèlement à celle-ci étant disposée.

11. Agencement en deux et/ou trois dimensions de touches (1) selon l'une des revendications 1-9 ou d'empiècements de soudure (27) selon la revendication 10, dans lequel les touches (1), respectivement les empiècements de soudure, (27) sont reliés ensemble via les pieds de soudure (6) et/ou les liaisons de montage (19).

12. Procédé pour la fabrication d'une touche selon l'une des revendications 1-9 ou bien pour la fabrication d'un agencement selon la revendication 11, **caractérisé en ce que** l'on place dans un moule à injection ou un moule de compression la pastille de contact ainsi que les pieds de soudure (6) ou les empiècements de soudure (27), ainsi que le cas échéant un élément d'éclairage (13) et des éléments de contact (14, 25), et **en ce que** l'on injecte ensuite une matière élastique isolante en la laissant au moins partiellement durcir dans le moule.

13. Procédé selon la revendication 12, **caractérisé en ce que** l'on fabrique un agencement selon la revendication 11 et **en ce que** celui-ci est ensuite séparé, en particulier de préférence le long d'une arête de séparation (16), laquelle résulte en la formation de deux tronçons du renforcement (11) séparés électriquement l'un de l'autre, en touches individuelles.

14. Utilisation d'une touche selon l'une des revendications 1-9 pour la fixation sur une carte de circuits imprimés (8), en particulier en faisant appel à un processus de soudage via les pieds de soudure (6), en particulier de préférence dans le cadre de la technologie SMT.
